# EUROPÄISCHE PATENTANMELDUNG

(11) **EP 3 712 462 A1**
(43) Veröffentlichungstag der Anmeldung: **23.09.2020**
(21) Anmeldenummer: 19163715.6
(22) Anmeldetag: 19.03.2019
(51) Int. Cl.: F16F 15/03, G03F 7/20, H01F 7/02, H01F 7/06, H02K 11/01, H02K 41/02, H02K 33/18, H02K 5/04, H02K 41/035

(54) **SCHWINGUNGSISOLATIONSSYSTEM MIT EINEM MAGNETAKTOR**

(71) Anmelder: Integrated Dynamics Engineering GmbH, 65479 Raunheim (DE)
(72) Erfinder: HARTGERS, Han, 55122 Mainz (DE); EVERS, Arndt, 65375 Oestrich-Winkel (DE); SCHADT, Simon, 65195 Wiesbaden (DE)
(74) Vertreter: Blumbach · Zinngrebe Patentanwälte PartG mbB

(57) **Zusammenfassung**

Aktives Schwingungsisolationssystem mit einem Magnetaktor. Der Magnetaktor umfasst einen Spulenträger mit zumindest einer Spule, welcher berührungslos in einen Magnetträger greift, so dass dieser in der Art eines Linearmotors ausgebildet ist. Der Magnetaktor ist mit einer magnetischen Abschirmung versehen, welche eine Öffnung aufweist, durch die der Spulenträger in den Magnetträger hineinragt.

## Beschreibung

### Gebiet der Erfindung

Die Erfindung betrifft ein Schwingungsisolationssystem mit einem Magnetaktor. Insbesondere betrifft die Erfindung ein stationäres Schwingungsisolationssystem, auf welchem Geräte zur Prozessierung von Halbleiterbauelementen platziert sind.

Die Erfindung betrifft des Weiteren einen Magnetaktor für ein Schwingungsisolationssystem.

### Hintergrund der Erfindung

Aktive Schwingungsisolationssysteme sind aus der Praxis bekannt. Insbesondere in der Halbleiterindustrie werden Schwingungsisolationssysteme verwendet, bei welchen ein Gerät zur Prozessierung von Halbleiterbauelementen, beispielsweise ein Gerät zur Belichtung oder Inspektion von Wafern, auf zumindest drei Schwingungsisolatoren gelagert ist.

Ein aktives Schwingungsisolationssystem umfasst dabei Sensoren an der schwingungsisoliert gelagerten Last und/oder am Boden, über welche Schwingungen erfasst werden. Anhand der erfassten Schwingungen wird mittels eines Controllers ein Aktor angesteuert, welcher an der schwingungsisoliert gelagerten Last angreift und Gegenkräfte erzeugt, um die Schwingungen der schwingungsisoliert gelagerten Last zu reduzieren.

Als Aktoren werden insbesondere Magnetaktoren verwendet. Diese sind nach dem Prinzip eines Linearmotors aufgebaut und haben den Vorteil, dass sich auf kleinem Bauraum verhältnismäßig große Kräfte in einem breiten Frequenzbereich erzeugen lassen.

Nachteilig an bekannten Magnetaktoren sind allerdings die von den Permanentmagneten und/oder den Spulen erzeugten Magnetfelder.

Diese können magnetisch empfindliche Geräte, wie beispielsweise Rasterelektronenmikroskope, stören und können daher oft nicht in der Nähe des Geräts eingebaut werden.

### Aufgabe der Erfindung

Der Erfindung liegt demgegenüber die Aufgabe zugrunde, die genannten Nachteile des Standes der Technik zumindest zu reduzieren.

### Zusammenfassung der Erfindung

Die Aufgabe der Erfindung wird bereits durch ein Schwingungsisolationssystem sowie einen Magnetaktor für ein Schwingungsisolationssystem nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein Schwingungsisolationssystem, welches eine schwingungsisoliert gelagerte Last umfasst, wobei das Schwingungsisolationssystem zumindest einen über einen Controller angesteuerten Magnetaktor aufweist.

Die Erfindung betrifft insbesondere ein stationäres Schwingungsisolationssystem, bei welchem eine Platte auf zumindest drei Schwingungsisolatoren schwingungsisoliert gelagert ist. Das Schwingungsisolationssystem dient insbesondere der Aufnahme von Geräten zur Prozessierung von Halbleiterbauelementen, wie beispielsweise Lithografiegeräten oder Waferinspektionsgeräten.

Der Magnetaktor greift an der schwingungsisoliert gelagerten Last an und erzeugt Gegenkräfte zur Reduktion von Schwingungen in zumindest einer Raumrichtung.

Der Magnetaktor ist insbesondere als Linearmotor ausgebildet und umfasst einen Spulenträger mit zumindest einer Spule, welcher in einem U-förmig ausgebildeten Magnetträger angeordnet ist.

Gemäß der Erfindung umfasst der Magnetaktor eine magnetische Abschirmung.

Die Erfindung sieht also vor, den Magnetaktor mit einer als magnetische Abschirmung dienenden Einhausung zu versehen.

Die magnetische Schirmung besteht insbesondere aus einem Weichmetall.

Durch die magnetische Abschirmung wird das im Inneren des Magnetaktors vorhandene oder entstehende Magnetfeld umgelenkt und gebündelt, so dass es sich außerhalb stark abschwächt.

Die magnetische Abschirmung besteht insbesondere aus einem Material mit einer Permeabilitätszahl µᵣ von über 1.000, vorzugsweise von über 10.000 und besonders bevorzugt von über 50.000.

Insbesondere besteht die magnetische Abschirmung aus einem Mu-Metall. Es handelt sich dabei um eine weichmagnetische Eisen-Nickel-Legierung, welche typischerweise eine Permeabilitätszahl µᵣ von 80.000 bis 500.000 hat.

Die magnetische Abschirmung ist vorzugsweise als Gehäuse mit einer Öffnung in einer Wand ausgebildet, aus welcher ein Arm des Magnetaktors, insbesondere ein Spulenträger, herausragt.

Die Öffnung ist vorzugsweise so bemessen, dass der Spulenträger berührungslos in den Magnetträger hineinragt, der sich um den Spulenträger erstreckende Spalt aber möglichst klein gehalten ist, insbesondere eine maximale Breite von weniger als 2 mm, vorzugsweise weniger als 1 mm hat.

Die magnetische Abschirmung kann insbesondere als rechteckig ausgebildetes Gehäuse mit zusammengesetzten Wänden bereitgestellt sein. Die Permeabilität schwächende Verformungen des Materials müssen so zu dessen Herstellung nicht vorgenommen werden.

Bei einer anderen Ausführungsform umfasst der Magnetaktor eine Umwicklung mit einer magnetischen Abschirmung. Diese kann insbesondere mehrlagig ausgebildet sein. So werden trotz der Umwicklung die Permeabilität schwächende Verformungen geringgehalten.

Es hat sich gezeigt, dass bereits recht dünne Umwicklungen aus Mu-Metall, insbesondere mehrlagige Umwicklungen mit einer Gesamtdicke von unter 1 mm, vorzugsweise unter 0,5 mm zu einer deutlichen Reduktion des von den Magnetaktoren verursachten Feldes führen.

Die magnetische Abschirmung kann insbesondere eine Dicke von 0,1 bis 10 mm, vorzugsweise von 0,2 bis 1 mm, aufweisen.

Gemäß einer Ausführungsform der Erfindung ist der Magnetaktor in einem Schwingungsisolator integriert. Der Schwingungsisolator umfasst eine Feder und dient der schwingungsisolierten Lagerung der zu isolierenden Last. Die Feder kann beispielsweise als pneumatische Feder ausgebildet sein. Der erfindungsgemäße Magnetaktor kann in dem Isolator, beispielsweise im Arbeitsraum der pneumatischen Feder, oder im Gehäuse der pneumatischen Feder angeordnet sein.

Die Erfindung ermöglicht auch das Anbringen eines Magnetaktors in der Nähe eines Gerätes zur Prozessierung von Halbleiterbauelementen. Insbesondere kann der erfindungsgemäße Magnetaktor auch in einem Abstand von weniger als 50 cm von einem Gerät zur Prozessierung von Halbleiterbauelementen, beispielsweise von einem Rasterelektronenmikroskop, platziert sein.

Bei einer weiteren bevorzugten Ausführungsform umfasst das Schwingungsisolationssystem zumindest zwei Magnetaktoren zum Erzeugen von Kompensationssignalen in zwei zumindest zwei unterschiedlichen Raumrichtungen.

Die Erfindung betrifft des Weiteren einen Magnetaktor für ein Schwingungsisolationssystem, insbesondere für das vorstehend beschriebene Schwingungsisolationssystem.

Der Magnetaktor umfasst einen Magnetträger mit sich gegenüberliegenden Magneten.

Der Magnetträger ist insbesondere U-förmig mit zwei sich gegenüberliegenden Schenkeln ausgebildet, wobei die Magnete sich paarweise gegenüberliegen und die Pole der Magnete sich ebenfalls gegenüberliegen, also die entgegengesetzten Pole gegenüber angeordnet sind.

Zwischen den Magneten ist berührungslos ein Spulenträger mit zumindest einer Spule angeordnet.

Des Weiteren umfasst der Magnetaktor eine magnetische Abschirmung, welche eine Öffnung umfasst, aus welcher der Spulenträger herausragt.

Der Magnetaktor kann insbesondere wie vorstehend im Zusammenhang mit dem Schwingungsisolationssystem beschrieben ausgebildet sein, also die vorstehenden, im Zusammenhang mit dem Magnetaktor beschriebenen Merkmale aufweisen.

Insbesondere kann die Abschirmung aus einem Material mit einer Permeabilitätszahl µᵣ von über 1.000, vorzugsweise über 10.000 und besonders bevorzugt über 50.000 bestehen.

Beispielsweise besteht die magnetische Abschirmung aus einem Mu-Metall.

Gemäß einer Ausführungsform umgibt die magnetische Abschirmung den Magnetträger.

Gemäß dieser Ausführungsform der Erfindung ist die magnetische Abschirmung also als zusätzliches Gehäuse ausgebildet, welches sich um den ansonsten aus dem Stand der Technik bekannten Magnetaktor erstreckt.

Diese Ausführungsform der Erfindung hat den Vorteil, dass das Material der magnetischen Abschirmung einzig und allein auf eine besonders gute magnetische Abschirmung optimiert sein muss.

Gemäß einer anderen Ausführungsform der Erfindung bildet der Magnetträger selbst einen Teil der magnetischen Abschirmung.

Gemäß dieser Ausführungsform der Erfindung ist also der Magnetträger aus einem derartigen Material gefertigt und derart dimensioniert, dass die Schenkel des Spulenträgers und die Verbindungsplatte für die beiden Schenkel bereits eine Abschirmung bilden.

Vorzugsweise wird für diese Ausführungsform der Erfindung kein Mu-Metall, sondern ein ferromagnetisches Weicheisen verwendet, welches billiger ist und sich einfacher verarbeiten lässt.

Die so als Abschirmung dienenden Wände müssen gegenüber einem Mu-Metall dicker ausgebildet sein, um die gleiche Abschirmung zu erreichen.

Die offenen Seiten des U-förmigen Magnetträgers werden gemäß dieser Ausführungsform der Erfindung mit als Abschirmung dienenden Wänden versehen.

Vorzugsweise umfasst das so gleichzeitig als Magnetträger und Abschirmung dienende Gehäuse lediglich eine einzige Öffnung, in welche der Spulenträger berührungslos hineinragt.

Gemäß einer bevorzugten Ausführungsform der Erfindung umfasst der Magnetaktor zum Erzeugen möglichst hoher Kräfte zumindest zwei sich gegenüberliegende Magnetpaare, zwischen denen die Windungen der Spule angeordnet sind.

### Kurzbeschreibung der Zeichnungen

Der Gegenstand der Erfindung soll im Folgenden anhand schematisch dargestellter Ausführungsbeispiele gemäß Fig. 1 bis Fig. 3 sowie anhand eines perspektivisch dargestellten Ausführungsbeispiels anhand Fig. 4 und 5 näher erläutert werden.

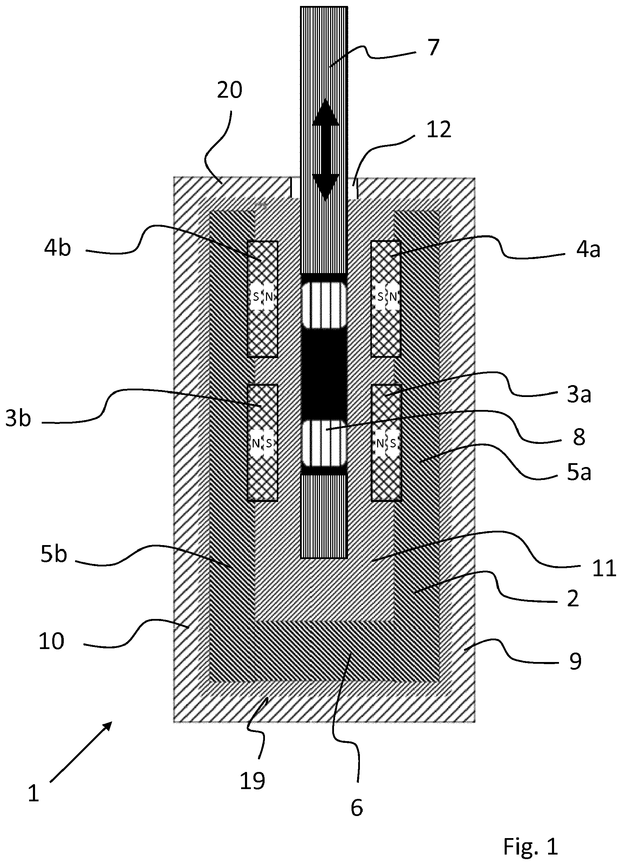

Fig. 1 zeigt in einer schematischen Schnittansicht ein erstes Ausführungsbeispiel der Erfindung, bei welchem der Magnetaktor als magnetische Abschirmung eine Einhausung aus einem Material mit hoher Permeabilitätszahl aufweist.

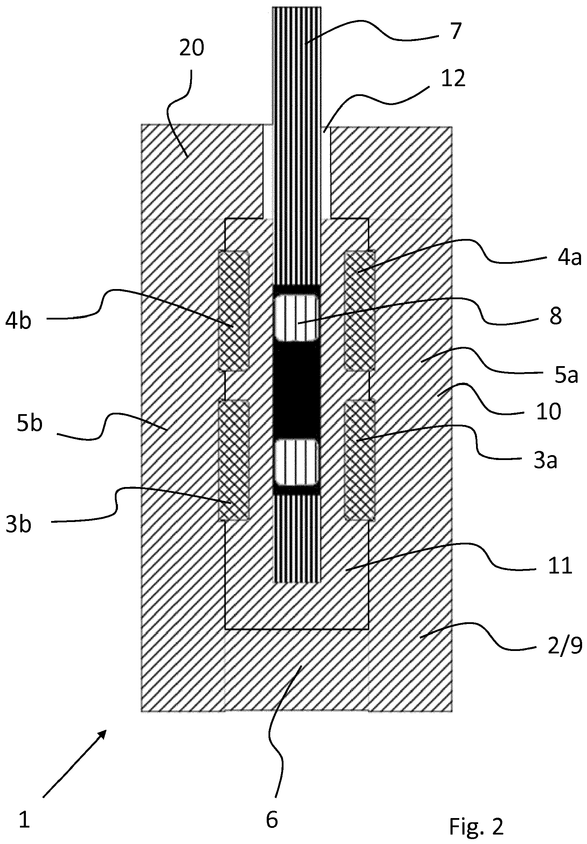

Fig. 2 zeigt schematisch eine alternative Ausführungsform der Erfindung, bei welcher der Magnetträger des Magnetaktors gleichzeitig Teil der magnetischen Abschirmung ist.

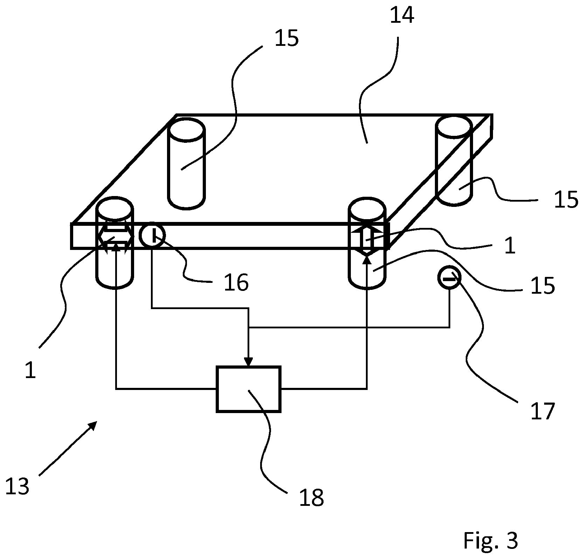

Fig. 3 ist eine schematische Ansicht eines Schwingungsisolationssystems, in welchem der erfindungsgemäße Magnetaktor eingebaut ist.

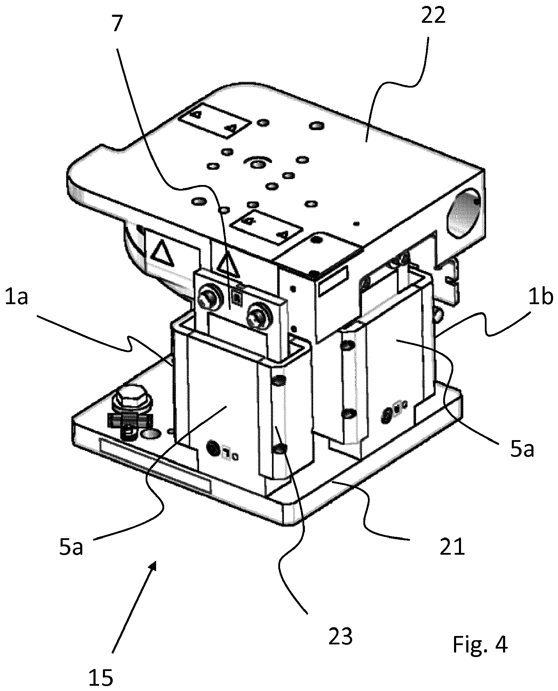

Fig. 4 ist eine perspektivische Ansicht eines Schwingungsisolators, welcher mit zwei Magnetaktoren versehen ist.

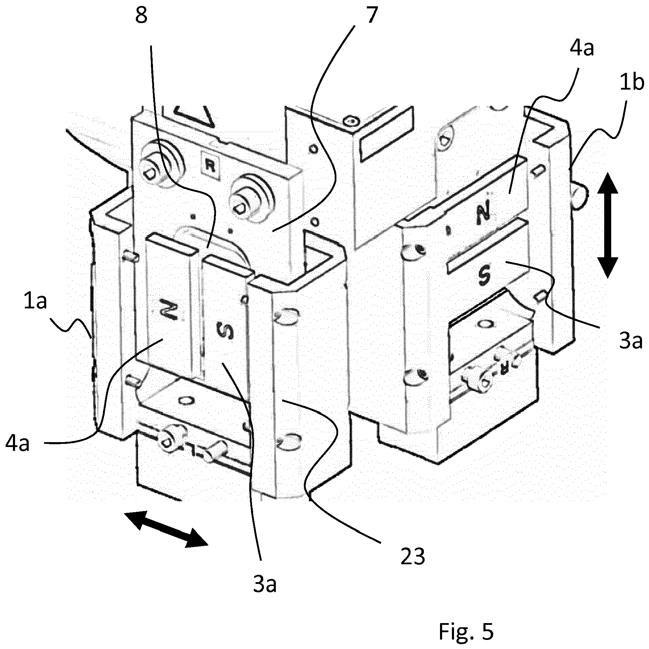

Fig. 5 ist eine Detailansicht, in welcher das Innere der Magnetaktoren dargestellt ist.

### Detaillierte Beschreibung der Zeichnungen

Fig. 1 zeigt in einer schematischen Schnittansicht ein Ausführungsbeispiel eines Magnetaktors 1, welcher zur Verwendung in einem Schwingungsisolationssystem vorgesehen ist.

Der Magnetaktor 1 umfasst einen Magnetträger 2.

Der Magnetträger 2 ist U-förmig ausgebildet und umfasst zwei sich gegenüberliegende Schenkel 5a, 5b, welche auf einer Seite mittels der Platte 6 miteinander verbunden sind.

An den Schenkeln 5a, 5b angebracht sind in diesem Ausführungsbeispiel zwei sich jeweils gegenüberliegende Magnetpaare 3a, 3b sowie 4a, 4b vorgesehen.

Die Magnete 3a, 3b, 4a, 4b sind an den Schenkeln 5a, 5b befestigt, insbesondere eingeklebt.

Die Pole der Magnetpaare 3a, 3b sowie 4a, 4b liegen sich jeweils gegenüber. Dementsprechend läuft das Magnetfeld jeweils von einem Schenkel 5a zum anderen Schenkel 5b.

Die Magnete 3a, 3b, 4a, 4b sind in diesem Ausführungsbeispiel derart angeordnet, dass die Magnetfelder der beiden Magnetpaare 3a, 3b sowie 4a, 4b entgegengesetzt ausgerichtet sind.

In den Magnetträger 2 ragt berührungslos der in diesem Ausführungsbeispiel plattenförmig ausgebildete Spulenträger 7 hinein, welcher die Spule 8 umfasst, deren Windungen sich zwischen den Magnetpaaren 3a, 3b sowie 4a, 4b erstrecken.

Durch Beaufschlagen der Spule 8 mit einem Stromfluss und die daraus resultierende Erzeugung eines magnetischen Feldes kann mittels des Magnetaktors 1 eine Kraft in zwei Richtungen (je nach Stromflussrichtung, mit dem Pfeil gekennzeichnet) erzeugt werden.

Der Spulenträger 7 kann dabei beispielsweise an der zu isolierenden Last angreifen. Es ist aber genauso gut die umgekehrte Anordnung denkbar, bei welcher der Magnetträger 2 an der schwingungsisoliert gelagerten Last angeordnet ist und der Spulenträger 7 an der Basis des Schwingungsisolationssystems angreift.

Erfindungsgemäß umfasst der Magnetaktor 1 eine magnetische Abschirmung 9.

Die magnetische Abschirmung 9 ist in diesem Ausführungsbeispiel als Einhausung des Magnetträgers 2 ausgebildet.

Die magnetische Abschirmung umfasst die Seitenwände 10 sowie die Rückwand 11. Die Vorderwand ist in dieser Schnittansicht nicht zu sehen.

Die magnetische Abschirmung 9 erstreckt sich auch entlang einer Unterseite 19 und einer Oberseite 20 eines durch die magnetische Abschirmung 9 gebildeten Gehäuses.

Die magnetische Abschirmung 9 weist lediglich eine Öffnung 12 auf, durch welche der Spulenträger 7 berührungslos in das durch die magnetische Abschirmung 9 gebildete Gehäuse bis in den Magnetträger 2 hineinragt.

Die Öffnung ist vorzugsweise derart ausgebildet, dass diese nur einen schmalen Spalt ausbildet, welcher sich um den Spulenträger 7 erstreckt.

Die magnetische Abschirmung 9 ist in diesem Ausführungsbeispiel vorzugsweise aus einem Mu-Metall ausgebildet.

Insbesondere kann es sich bei der Abschirmung um eine mehrlagige Umwicklung aus Mu-Metall handeln.

Fig. 2 ist eine schematische Ansicht einer alternativen Ausführungsform der Erfindung.

Im Gegensatz zu der in Fig. 1 dargestellten Ausführungsform dient der Magnetträger 2 gleichzeitig als magnetische Abschirmung.

Die Schenkel des Magnetträgers 2 ist dicker ausgebildet als in dem Ausführungsbeispiel gemäß Fig. 2 und bilden die Seitenwände 10 der magnetischen Abschirmung 9 aus.

Die Platte 6 zur Verbindung der Schenkel 5a, 5b des Magnetträgers 2 dient als Boden.

Im Unterschied zu aus dem Stand der Technik bekannten Magnetaktoren ist eine Rückwand 11 sowie eine Vorderwand (nicht dargestellt) vorgesehen. Lediglich in der Oberseite 20 des so durch die magnetische Abschirmung 9 gebildeten Gehäuses ist entsprechend Fig. 1 eine Öffnung 12 vorgesehen, durch welche der Spulenträger 7 mit den Spulen 8a und 8b berührungslos in das durch die magnetische Abschirmung 9 gebildete Gehäuse hineinragt, so dass die Spule 8 zwischen den Magnetpaaren 3a, 3b und 4b, 4b entlangläuft.

Fig. 3 ist eine schematische Ansicht eines Schwingungsisolationssystems, in welchem der in Fig. 1 oder Fig. 2 dargestellte Magnetaktor verwendet wird.

Das Schwingungsisolationssystem 13 ist als aktives Schwingungsisolationssystem ausgebildet und umfasst eine Platte 14, welche auf Schwingungsisolatoren 15, beispielsweise auf Luftfedern, schwingungsisoliert gelagert ist.

Die Platte 15 dient der Aufnahme eines Gerätes zur Prozessierung von Halbleiterbauelementen (nicht dargestellt).

In diesem Ausführungsbeispiel sind die Magnetaktoren 1 zur aktiven Schwingungsisolation in dem Gehäuse der Schwingungsisolatoren 15 integriert.

Das Schwingungsisolationssystem ist derart ausgebildet dass das von den Magnetaktoren im Betrieb verursachte Magnetfeld in der Mitte der Platte 14 immer unter 10 nT liegt.

Das Schwingungsisolationssystem umfasst zumindest einen Sensor 16 an der schwingungsisoliert gelagerten Last und/oder am Boden 17.

Das Signal des oder der Sensoren 16, 17 wird von einem Controller 18 verarbeitet, welcher die Magnetaktoren 1 zur aktiven Reduktion von Schwingungen ansteuert. Es kann so der Prolongation von außen auf das System einwirkenden Schwingungen entgegengewirkt werden.

Weiter können auch Schwingungen, die von der schwingungsisoliert gelagerten Last, wie beispielsweise einer verfahrbaren Bühne, verursacht werden, entgegengewirkt werden.

Aufgrund der magnetischen Abschirmung der Magnetaktoren 1 können diese auch nah an einem gegenüber magnetischen Feldern empfindlichen Gerät angeordnet sein.

Fig. 4 ist eine perspektivische Ansicht eines Ausführungsbeispiels eines Schwingungsisolators 15. Der Schwingungsisolator 15 umfasst ein Unterteil 21, welches im eingebauten Zustand mit dem Boden verbunden wird.

Weiter umfasst der Schwingungsisolator 15 das Oberteil 22, welches mit der schwingungsisolierten Last verbunden wir, insbesondere welches mit der in Fig. 3 dargestellten Platte (Bezugszeichen 14) verbunden wird.

Zwischen Oberteil 22 und Unterteil 21 befindet sich eine pneumatische Feder, welche in dieser Ansicht von den Magnetaktoren 1a, 1b verdeckt ist.

Die Magnetaktoren 1a, 1b sind in diesem Ausführungsbeispiel in etwa randseitig an zwei Ecken des Schwingungsisolators angebracht.

Der Magnetaktor 1a dient der horizontalen Schwingungsisolation.

Zu erkennen ist ein Schenkel 5a.

Der Spulenträger 7 greift zwischen den Schenkel 5a und den gegenüberliegenden Schenkel, welcher in dieser Ansicht nicht dargestellt ist.

Randseitig ist an dem durch die Schenkel gebildeten Magnetträger je ein Seitenteil 23 angeordnet, welches den durch die Schenkel 5a gebildeten Spulenträger verdeckt.

Fig. 5 ist eine Detailansicht des Schwingungsisolators mit teilweise ausgeblendetem Spulenträger, d.h. der vordere Schenkel (5a in Fig. 4) ist bei beiden Magnetaktoren 1a, 1b ausgeblendet. Der Magnetaktor 1b, welcher zur vertikalen Isolation vorgesehen ist, entspricht dem in Fig. 1 dargestellten Aufbau, in welchem zwei Magnetpaare mit gegensätzlicher Polung vertikal in dem Magnetträger übereinander angeordnet sind.

Zu erkennen sind in dieser Ansicht die Magnete 3a und 4a.

So kann über eine Ansteuerung der in dieser Ansicht verdeckten Spule eine Kompensationskraft in vertikaler Richtung erzeugt werden.

Bei dem Magnetaktor 1a für die horizontale Isolation sind die Magnetpaare um 90° gedreht.

Die Magnetpaare, von denen man die Magnete 3a und 4a sieht, sind nicht übereinander, sondern nebeneinander angeordnet.

Die Spule 8 ist derart ausgebildet, dass deren Windungen ebenfalls zwischen den Magnetpaaren hindurchlaufen.

Durch Ansteuerung einer Spule können Kompensationskräfte in horizontaler Richtung erzeugt werden.

Die auf den Spulenträger 7 beispielsweise aufgeklebte Spule 8 hat in diesem Ausführungsbeispiel in der Draufsicht einen im Wesentlichen rechteckigen Querschnitt mit abgerundeten Ecken.

Erfindungsgemäß wird das Gehäuse der hier dargestellten Magnetaktoren 1a, 1b noch mit einer mehrlagigen Abdeckung aus Mu-Metall versehen (nicht dargestellt), über die das von den Magnetaktoren 1a, 1b verursachte Magnetfeld deutlich reduziert wird.

Durch die Erfindung konnte auf recht einfache Weise der Anwendungsbereich von Magnetaktoren in einem Schwingungsisolationssystem vergrößert werden.

### Bezugszeichenliste

- 1: Magnetaktor
- 2: Magnetträger
- 3a, 3b: Magnet
- 4a, 4b: Magnet
- 5a, 5b: Schenkel
- 6: Platte
- 7: Spulenträger
- 8: Spule
- 9: magnetische Abschirmung
- 10: Seitenwand der magnetischen Abschirmung
- 11: Rückwand der magnetischen Abschirmung
- 12: Öffnung der magnetischen Abschirmung
- 13: Schwingungsisolationssystem
- 14: Platte
- 15: Schwingungsisolator
- 16: Sensor (Last)
- 17: Sensor (Boden)
- 18: Controller
- 19: Unterseite
- 20: Oberseite
- 21: Basisteil
- 22: Oberteil
- 23: Seitenteil

## Patentansprüche

1. Schwingungsisolationssystem, umfassend eine schwingungsisoliert gelagerte Last, wobei das Schwingungsisolationssystem zumindest einen über einen Controller angesteuerten Magnetaktor umfasst, welcher an der schwingungsisoliert gelagerten Last angreift und Gegenkräfte zur Reduktion von Schwingungen erzeugt,
**dadurch gekennzeichnet, dass** der Magnetaktor eine magnetische Abschirmung umfasst.

2. Schwingungsisolationssystem nach dem vorstehenden Anspruch, **dadurch gekennzeichnet, dass** die magnetische Abschirmung aus einem Material mit einer Permeabilitätszahl µᵣ von über 1000, vorzugsweise über 10.000 und besonders bevorzugt über 50.000 besteht.

3. Schwingungsisolationssystem nach einem der vorstehenden Ansprüche, **dadurch gekennzeichnet, dass** die magnetische Abschirmung aus einem Mu-Metall besteht.

4. Schwingungsisolationssystem nach einem der vorstehenden Ansprüche, **dadurch gekennzeichnet, dass** die magnetische Abschirmung als Gehäuse mit einer Öffnung in einer Wand ausgebildet ist, aus welcher ein Arm des Magnetaktors, insbesondere ein Spulenträger, herausragt.

5. Schwingungsisolationssystem nach einem der vorstehenden Ansprüche, **dadurch gekennzeichnet, dass** der Magnetaktor in einem Schwingungsisolator integriert ist.

6. Schwingungsisolationssystem nach einem der vorstehenden Ansprüche, **dadurch gekennzeichnet, dass** das Schwingungsisolationssystem zumindest zwei Magnetaktoren zum Erzeugen von Kompensationssignalen in zumindest zwei unterschiedlichen Raumrichtungen umfasst.

7. Schwingungsisolationssystem nach einem der vorstehenden Ansprüche, umfassend eine auf Schwingungisolatoren gelagerte Platte zur Aufnahme eines schwingungsisoliert zu lagerndes Gerätes, wobei die Schwingungsisolatoren zumindest einen Magnetaktor umfassen, wobei das in der Mitte der Platte von den Magnetaktoren verursachte Magnetfeld weniger als 10 nT beträgt.

8. Magnetaktor, insbesondere für ein
Schwingungsisolationssystem nach einem der vorstehenden Ansprüche, umfassend einen Magnetträger mit sich gegenüberliegenden Magneten, einen zwischen den Magneten angeordneten Spulenträger mit zumindest einer Spule, wobei der Magnetaktor eine magnetische Abschirmung umfasst, und wobei die magnetische Abschirmung eine Öffnung umfasst, aus welcher der Spulenträger herausragt.

9. Magnetaktor nach dem vorstehenden Anspruch, **dadurch gekennzeichnet, dass** die magnetische Abschirmung aus einem Material mit einer Permeabilitätszahl µᵣ von über 1000, vorzugsweise über 10.000 und besonders bevorzugt über 50.000, insbesondere aus einem Mu-Metall, besteht.

10. Magnetaktor nach einem der vorstehenden Ansprüche, **dadurch gekennzeichnet, dass dadurch gekennzeichnet, dass** die magnetische Abschirmung den Magnetträger umgibt.

11. Magnetaktor nach Anspruch 8 oder 9, **dadurch gekennzeichnet, dass** der Magnetträger einen Teil der magnetischen Abschirmung bildet.

12. Magnetaktor nach einem der vorstehenden Ansprüche, **dadurch gekennzeichnet, dass** die Wände der magnetischen Abschirmung eine Dicke von 0,1 bis 10 mm, vorzugsweise von 0,2 bis 1 mm aufweisen.

13. Magnetaktor nach einem der vorstehenden Ansprüche, **dadurch gekennzeichnet, dass** die Pole der sich gegenüberliegen Magneten sich gegenüberliegen.

14. Magnetaktor nach einem der vorstehenden Ansprüche, **dadurch gekennzeichnet, dass** der Magnetaktor zumindest zwei sich gegenüberliegende Magnetpaare, zwischen den die Windungen der Spule verlaufen, umfasst.

15. Magnetaktor nach einem der vorstehenden Ansprüche, **dadurch gekennzeichnet, dass** der Magnetträger U-förmig ausgebildet ist.
